(19) Europäisches Patentamt
European Patent Office
Office européen des brevets

(11) Publication number: **0 384 521 A1**

(12) **EUROPEAN PATENT APPLICATION**

(21) Application number: **90200340.9**

(51) Int. Cl.5: **H01L 39/22, H01L 39/24**

(22) Date of filing: **14.02.90**

(30) Priority: **20.02.89 NL 8900405**

(43) Date of publication of application: **29.08.90 Bulletin 90/35**

(84) Designated Contracting States: **DE FR GB NL**

(71) Applicant: **N.V. Philips' Gloeilampenfabrieken**
**Groenewoudseweg 1**
**NL-5621 BA Eindhoven(NL)**

(72) Inventor: **Gijs, Martinus Adela Maria**
**c/o INT. OCTROOIBUREAU B.V., Prof. Holstlaan 6**
**NL-5656 AA Eindhoven(NL)**

(74) Representative: **Pennings, Johannes et al**
**Internationaal Octrooibureau B.V. Prof. Holstlaan 6**
**NL-5656 AA Eindhoven(NL)**

(54) **Method of manufacturing a Josephson junction.**

(57) The invention relates to a method of manufacturing a Josephson junction comprising two layers 11, 11′ of an oxidic superconducting material, between which at least one non-superconducting layer 12 is provided. The method provides accurately defined junctions, the accuracy not being disturbed by a treatment at high temperature. To this end, two layers of oxidic superconducting material are each covered with a noble metal layer and pressed together at a temperature below 250° C.

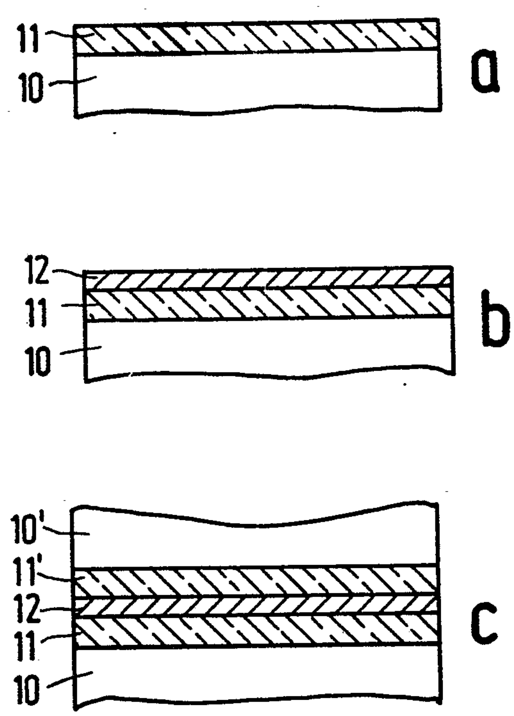


FIG.1

EP 0 384 521 A1

## Method of manufacturing a Josephson junction.

The invention relates to a method of manufacturing a Josephson junction comprising two layers of an oxidic superconducting material, between which at least one non-superconducting layer is provided.

Such a method is described in an article by M.G. Blamire et. al., in J. Phys. D. Appl. Phys. 20, pages 1330-1335 (1987). In this article a sapphire substrate is coated with a $Y_2O_3$ buffer layer on which a first oxidic superconducting layer of $YBa_2Cu_3O_{7-\delta}$ is deposited. Subsequently, a thin film of $Y_2O_3$ is provided which serves as a tunnel barrier. Next, a second layer of $YBa_2Cu_3O_{7-\delta}$ is applied, on which contacts of Nb may be provided. The thin films are manufactured by means of dc-magnetron sputtering using metal target plates in an oxidizing atmosphere. Patterns are formed in the films by means of plasma etching or ion etching.

Thin films of oxidic superconducting material can be obtained by using different methods which are known per se. In general, a high-temperature treatment is required to obtain the desired composition, in particular, as regards the oxygen balance and the valence of metal atoms, particularly copper atoms. According to M. Gurvitch et. al. in Appl. Phys. Lett. 51 (13), pages 1029-1029 (1987) thin films of the oxidic superconducting material $YBa_2Cu_3O_{7-\delta}$ are manufactured, for example, by means of dc magnetron sputter deposition using metal target plates in an oxidizing atmosphere, followed by firing at a high temperature, for example 800 to 900° C. Other commonly used methods are vacuum evaporation, laser ablation and chemical deposition from the vapour phase. In Appl. Phys. Lett. 52 (21), pages 1828-1830 (1988), C.E. Rice et.al. describe a method of manufacturing thin films of Ca-Sr-Bi-Cu oxides by applying $CaF_2$, $SrF_2$, Bi and Cu by means of vacuum evaporation, followed by oxidation steps at 725° and 850° C. The high-temperature treatments are necessary to obtain a material having a high critical temperature $T_c$, i.e., the temperature below which superconducting behaviour occurs.

However, when the method described in the above article by M.G. Blamire et.al. is used for the manufacture of a junction of two layers of an oxidic superconducting material, the problem occurs that during the firing of the second layer the accurate definition of the layer structure is disturbed by diffusion, deformation and other processes taking place at high temperatures. This applies to the definition in the direction ofhickness of the layer (diffusion) as well as to the lateral definition if the layers are manufactured according to a pattern.

It is an object of the invention to provide a method of manufacturing a Josephson junction, in which the dimensions can be accurately defined. A particular object of the invention is to provide a method in which the accuracy is not adversely affected by a treatment at high temperature, which is generally required to obtain a properly superconducting material when oxidic superconducting materials are used. A further object of the invention is to provide a simple method of manufacturing a Josephson junction, independent of the availability of a process which can be conducted at a low temperature for the manufacture of an oxidic superconducting material.

According to the invention, this object is achieved by a method as described in the opening paragraph, in which two layers of oxidic superconducting material are each covered with a noble metal layer and pressed together at a temperature below 250° C.

In a suitable embodiment of the method according to the invention, the non-superconducting layer is a customary electrically conductive layer of a noble metal, preferably gold or silver.

In an alternative embodiment of the method according to the invention, an electrically insulating layer is applied to at least one of the noble metal layers before the superconducting layers are pressed together. By means of this method, a product is manufactured in which the non-superconducting layer is an electrically insulating layer which is connected to the superconducting layers through noble metal layers, preferably gold or silver. The insulating layers are manufactured from, for example, zirconium oxide or hafnium oxide.

In a very suitable embodiment of the method according to the invention, the superconducting layers are applied to substrates of strontium titanate.

The dimensional accuracy of the junction, obtained by means of the method according to the invention, is very important because the superconducting coherence length in oxidic superconductors is very small, in the order of 1 nm. Due to this, the characteristic properties of the junction are determined, in particular, by a thin film at the surface of the oxidic superconductor. For this reason, a particular advantage of the junctions manufactured by means of the method according to the invention is that the surface of the superconducting material contacts a noble metal, so that in the various processing steps of the method and the subsequent treatments the oxygen balance of the superconducting material is not disturbed.

The invention will be explained in greater detail by means of exemplary embodiments and with reference to a drawing, in which

Fig. 1 a-c schematically shows a number of steps of the method according to the invention,

Fig. 2 a-c schematically shows a number of steps of an alternative method according to the invention, and

Fig. 3 a-b schematically shows a particular embodiment of a method according to the invention.

Example 1.

Fig. 1a shows a substrate 10 of strontium titanate $SrTiO_3$ on which an oxidic superconducting layer 11 of $YBa_2Cu_3O_{6.7}$ is deposited, for example, by means of vacuum evaporation, the substrate being maintained at a temperature of 850°C. Other substrate materials, for example MgO, $Y_2O_3$ and substrates such as sapphire with protective buffer layers, for example $Ta_2O_5$, $LaF_3$ and $ZrO_2$ may also suitably be used in the method according to the invention.

Substitutions may be carried out in the superconducting material in known manner without affecting the effectivity of the method according to the invention. For example, Y may be completely or partially replaced by rare earth metal ions, Ba may be replaced by Sr or Ca, and O may be partly replaced by F. The invention may alternatively be applied using other oxidic superconducting materials such as Ca-Sr-Bi-Cu oxides, $(La, Sr)_2CuO_4$ and cuprates containing Ca and/or Ba in addition to Tl.

Instead of by means of vacuum evaporation, the layer 11 may alternatively be manufactured by means of sputtering using a target plate having the desired composition. In this process, the substrate is maintained at a high temperature, but deposition may also take place at a lower temperature. In the latter case an aftertreatment at a high temperature is required in order to obtain the desired superconducting properties.

In a suitable embodiment of the method according to the invention, the layer 11 is manufactured by means of dc triode sputtering at a voltage of 1 kV in Ar at a pressure of approximately 1 Pa. The material is converted into superconducting material by subjecting it to a thermal treatment at a temperature from 800 to 900° C in air for 4 hours.

A layer 12 of gold having a thickness from 0.1 to 10 µm, see Fig. 1b, is applied to the layer 11, for example, by means of vacuum evaporation. A post-firing treatment at 450° C is carried out to obtain a suitably conducting contact between the gold and the superconducting material. Gold may be suitably replaced by, for example, silver.

Two superconducting layers, each provided with a layer of a noble metal, are pressed together at a temperature of 200°C and a pressure of approximately 30 $N/mm^2$ in an oxygen atmosphere. Fig. 1c shows the junction manufactured in this manner, which comprises substrates 10, 10′, with superconducting layers 11, 11′, respectively, which are separated by a customary conducting layer 12.

Before the two parts of the junction are pressed together, the layers may be provided with patterns, in known manner, for example, by means of photolithographic techniques, followed by plasma etching or ion etching.

Example 2.

A Josephson junction is manufactured in the manner described in the previous example, with this difference that an electrically insulating layer is applied between the superconducting layers.

Fig. 2a shows a substrate 20′ of strontium titanate with a layer 21′ of $YBa_2Cu_3O_{6.7}$ to which a gold layer 22′ is applied. Fig. 2b shows a substrate 20 of strontium titanate with a layer 21 of $YBa_2Cu_3O_{6.7}$ to which a gold layer 22 is applied on which an electrically insulating layer 23 is deposited, in the present example of hafnium oxide $HfO_2$, having a thickness of, for example, 0.1 to 10 µm. The layer 23 is manufactured, for example, by means of vacuum evaporation of hafnium in an oxidizing atmosphere. Instead of hafnium oxide, for example, zirconium oxide $ZrO_2$ may be used alternatively.

Fig. 2c shows the result after pressing together the layers of Figs. 2a and 2b. The junction is formed by the superconducting layers 21, 21′ and the electrically insulating layer 23. Protective layers 22, 22′ of noble metal are located between the insulating layer and the superconducting layers. In the present example, the superconducting layers are provided on inert carriers 20, 20′.

Example 3.

A Josephson junction is manufactured in the manner described in example 1, with this difference that an additional layer is provided between at least one of the superconducting layers and the layer of a noble metal.

Fig. 3a shows a substrate 30′ of strontium titanate with a layer 31′ of $YBa_2Cu_3O_{6.7}$, to which a gold layer 32′ is applied. Fig. 3b shows a substrate 30 of strontium titanate with a layer 31 of $YBa_2Cu_3O_{6.7}$, which layer is covered with a layer 34 according to a desired pattern, the layer 34 being composed of a material which, at an increased temperature, reacts with the oxidic superconducting material, such that the superconducting behaviour disappears locally, for example, a layer of molybdenum or aluminium oxide. According to the example, an opening is provided in this layer, having a surface area of, for example, 10 $\mu m^2$. Subsequently, a gold layer 32 is applied and a junction is formed of the parts shown in Figs. 3a and 3b, in the indicated manner.

In this manner, the superconducting layer is partly covered with an insulating layer at its surface, as is also described in European Patent Application EP-A-0300567. In this manner, a Josephson junction is manufactured having a small effective surface area, but a large mechanical strength.

## Claims

1. A method of manufacturing a Josephson junction comprising two layers of an oxidic superconducting materiall between which at least one non-superconducting layer is provided, characterized in that two layers of oxidic superconducting material are each covered with a noble metal layer and pressed together at a temperature below 250° C.

2. A method as claimed in Claim 1, characterized in that the non-superconducting layer is a customary electrically conductive layer of a noble metal, preferably gold or silver.

3. A method as claimed in Claim 1, characterized in that an electrically insulating layer is applied to at least one of the noble metal layers before the superconducting layers are pressed together.

4. A method as claimed in Claim 3, characterized in that the non-superconducting layer is an electrically insulating layer which is connected to the superconducting layers via layers of a noble metal, preferably gold or silver.

5. A method as claimed in Claim 3 or 4, characterized in that the insulating layer is manufactured from zirconium oxide or hafnium oxide.

6. A method as claimed in any one of the Claims 1 up to and including 5, characterized in that the superconducting layers are applied to substrates of strontium titanate.

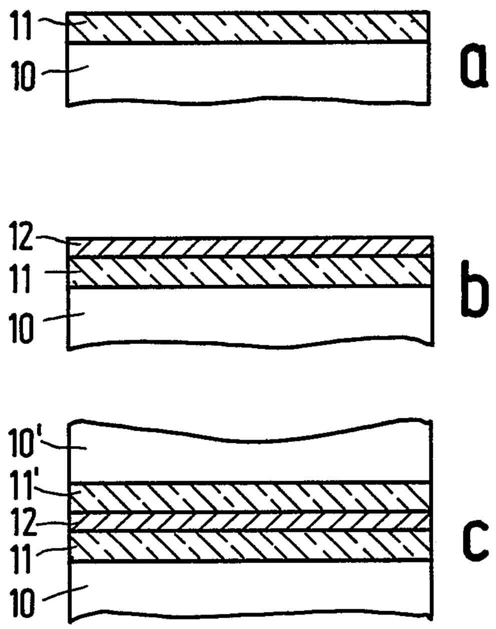


FIG.1

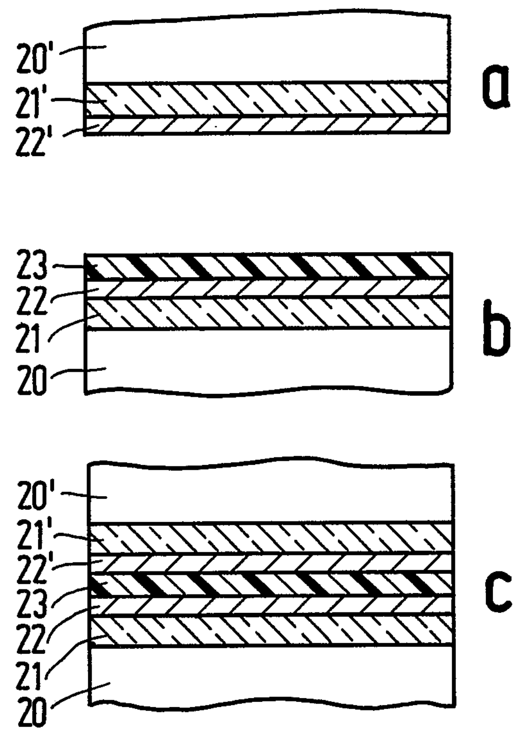


FIG.2

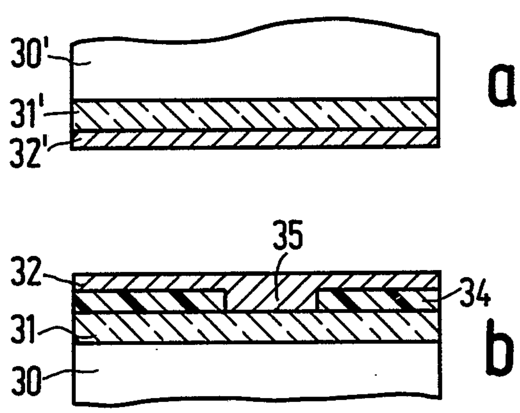


FIG.3

European Patent Office

# EUROPEAN SEARCH REPORT

Application Number

EP 90 20 0340

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | INDUSTRIAL CERAMICS, vol. 8, no. 1, 1988, pages 28-30: ""Hot" superconductors update"<br>* Page 29, columns 2-3; abstract; "Josephson Device" *<br>--- | 1 | H 01 L 39/24 |
| A | JOURNAL OF SUPERCONDUCTIVITY, vol. 1, no. 3, September 1988, pages 295-302, Plenum Publishing Corp., Bristol, GB; R.B. MARCUS et al.: "Electrostatic bonding of high-Tc superconducting films to any substrate"<br>* Abstract; paragraph 2; figures 1-2 *<br>--- | 1 | |
| A | EP-A-0 301 675 (UNIVERSITY OF TOKYO)(01-02-1989)<br>* Abstract; column 3, pages 32-58 *<br>--- | 3-5 | |
| A | US-A-3 999 203 (LAHIRI)(21-12-1976)<br>* Abstract; figure 30 *<br>--- | 3 | TECHNICAL FIELDS SEARCHED (Int. Cl.5) |
| A | JAPANESE JOURNAL OF APPLIED PHYSICS, part 2: "Letters", vol. 26, no. 8, August 1987, pages L1353-L1355, Tokyo, JP; S. KITA et al.: "Frequency dependence of AC Josephson effect in point-contact (Y,Er)BaCuO/Nb"<br>* Abstract *<br>----- | 1 | H 01 L 39/22<br>H 01 L 39/24 |

The present search report has been drawn up for all claims

| Place of search | Date of completion of the search | Examiner |
|---|---|---|
| THE HAGUE | 25-05-1990 | MIMOUN B.J. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)